# EUROPÄISCHE PATENTANMELDUNG

(11) **EP 2 518 102 A2**
(43) Veröffentlichungstag der Anmeldung: **31.10.2012**
(21) Anmeldenummer: 12165908.0
(22) Anmeldetag: 27.04.2012
(51) Int. Cl.: C08J 7/00, C23C 14/04, C23C 16/02

(54) **Vorrichtung und Verfahren zur Herstellung von beschichteten Verpackungsformteilen**

(30) Priorität: 29.04.2011 DE 102011050016
(71) Anmelder: Waldorf Technik GmbH & Co. KG, 78234 Engen (DE)
(72) Erfinder: Czizegg, Wolfgang, 78256 Steißlingen (DE)
(74) Vertreter: Wagner, Kilian

(57) **Zusammenfassung**

Vorrichtung zum Beschichten von durch Spritzgießen, Spritzblasen Blasformen und/oder Tiefziehen hergestellten Verpackungsformteilen (8) mit einem Aufnahmebereich (9) zur Aufnahme von Packgut, insbesondere von Kosmetik-, Lebens- oder Arzneimitteln, umfassend Zuführmittel (20) zum Zuführen von zu beschichtenden Verpackungsformteilen (8) in eine Zuführposition (22), Entnahmemittel (24) zum Entnehmen von beschichteten Verpackungsformteilen (8) aus einer Entnahmeposition (26), mindestens eine Trägereinheit (6) zum Tragen der Verpackungsformteile (8), Transportmittel zum Transport der mindestens einen Trägereinheit (6) von der Zuführposition (20) zur Entnahmeposition (26) auf einem Transportweg, Beschichtungsmittel (16) umfassend eine Vakuumkammer (18), die so ausgebildet sind, dass sie die zu beschichtenden Verpackungsformteile (8) mit einer Vakuumbeschichtung zum Erhöhen der Durchtrittssperrwirkung gegen Gase und/oder Feuchtigkeit, insbesondere Wasserdampf, beschichten, erfindungsgemäß ist vorgesehen dass auf dem Transportweg Maskiermittel (10) vorgesehen sind, die so ausgebildet sind, dass sie die zu beschichtenden Verpackungsformteile (8) vor Eintritt in die Beschichtungsmittel (16) in einer Maskierposition (11) mit mindestens einem Maskierkörper (14) maskieren, der ein Beschichten von Siegelbereichen der Verpackungsformteile (8) unterbindet, sowie dass auf dem Transportweg Demaskiermittel (12) vorgesehen sind, die von den beschichteten Verpackungsformteile (8) den mindestens einen Maskierkörper (14) nach Austritt aus den Beschichtungsmitteln (16) in einer Demaskierposition (13) wieder entfernen.

## Beschreibung

Die vorliegende Erfindung betrifft eine Vorrichtung zur Herstellung von beschichteten Verpackungsformteilen nach dem Oberbegriff des Anspruchs 1 sowie ein Verfahren zur Herstellung von beschichteten Verpackungsformteilen nach dem Oberbegriff des unabhängigen Anspruchs 13.

Aus der WO 2009/030425 A1 ist ein Verfahren und eine Vorrichtung zur Herstellung von Verpackungsteilen (unter anderem Spritzgussteile) mit einer Barriereschicht mit guter Durchtrittssperrwirkung gegen Wasserdampf und Gase bekannt. Die Verpackungsteile werden hier durch Thermoformen von Flachfolienmaterial, durch Spritzgießen oder durch eine Kombination von Spritzguss und Blasformen (injection blowmolding) oder Extrusion und Blasformen (extrusion blowmolding) geformt und sind aus Polyethylen (PE), Polypropylen (PP), Cycloolefincopolymer (COC), Cycloolefinpolymer (COP), Polyvinylchlorid (PVC), Polyethylenterephthalat (PET) oder Polyamid (PA), wobei auch kompostierbaren Polymeren, insbesondere auf Basis erneuerbarer Rohstoffe genannt werden. Anschließend werden die Verpackungsteile mittels Plasma-CVD Verfahren oder mittels Sputterverfahren mit einer keramischen und/oder metallischen Vakuumbeschichtung versehen.

Für den Beschichtungsvorgang verweist die WO 2009/030425 A1 auf die EP 1 048 746 B1. Dort erfolgt die Beschichtung in einem Beschichtungszyklus mithilfe eines Drehtellers. Bei einem solchen Drehteller stimmt die Belade- mit der Entladeposition überein, wodurch der Drehteller nicht gleichzeitig be- und entladen werden kann. Weiterhin kann der Drehteller nur als Ganzes gedreht werden, wodurch die einzelnen Stationen zeitlich an einander synchronisiert sein müssen.

Durch die Beschichtungen werden zwar einerseits erhöhte Durchtrittssperrwirkungen erzielt, andererseits erschweren sie in der Praxis das Siegeln an Siegelflächen. So kommt es nur zu ungenügendem Halt mit Standard-Siegelmethoden, wenn beispielsweise eine Deckelfolie unmittelbar auf die Beschichtung gesiegelt wird und es werden somit entweder haftvermittelnde Überlackschichten benötigt oder die Verpackungsteile müssen mit Stülp-, Schnapp- oder Klappdeckel verschlossen werden. Diese Lösungen machen jedoch das Endprodukt deutlich komplexer und sind somit mit weiteren Kosten verbunden.

Aufgabe der vorliegenden Erfindung ist es somit, ein Verfahren zum Beschichten von Verpackungsteilen so zu verbessern, dass es effizienter ist und die Kosten für das Endprodukt gesenkt werden. Insbesondere liegt der Erfindung die Aufgabe zugrunde auf möglichst einfache und effiziente Weise beschichtete Verpackungskörper herzustellen, die gut mit einer Deckelfolie siegelbar sind. Ergänzend ist es Ziel der Erfindung eine Anlage für die Herstellung solcher Verpackungen möglichst raumsparend auszugestalten.

Diese Aufgabe wird durch eine Vorrichtung mit den Merkmalen des Patentanspruchs 1, sowie durch ein Verfahren mit den Merkmalen des unabhängigen Patentanspruchs 13, gelöst. Vorteilhafte Weiterbildungen der Erfindung sind in den Unteransprüchen beschrieben. Im Rahmen der vorliegenden Erfindung gelten insbesondere auch die weiterbildungsgemäß angegebenen Funktionsmerkmale der Vorrichtung als weiterbildende Verfahrensschritte für das erfindungsgemäße Verfahren offenbart und beansprucht. Weiterhin gelten auch die weiterbildungsgemäß angegebenen Verfahrensschritte des Verfahrens als weiterbildende Funktionsmerkmale für die erfindungsgemäße Vorrichtung offenbart und beansprucht.

Bei einer erfindungsgemäßen Vorrichtung werden zu beschichtende Verpackungsformteile der Anlage, beispielsweise durch Vakuumgreifarme, der Beschichtungsvorrichtung zugeführt. Diese zu beschichtenden Verpackungsformteile werden hier auf Trägermittel aufgebracht, die beispielsweise durch eine Passform und/oder eine Auflagefläche etwa in Form eines Trays ausgebildet sein können. Weiterhin sind Transportmittel, beispielsweise Fließbänder, Schienen und/oder Rollen, vorgesehen, die die Trägereinheiten auf einem Transportweg unter anderem zu den Beschichtungsmittel hin und/oder durch diese hindurch befördern. In der Vakuumkammer der Beschichtungsmittel werden die Verpackungsformteile mit einer Vakuumbeschichtung beschichtet. Die Verpackungsformteile umfassen bevorzugt einen Aufnahmebereich zur Aufnahme von Packgut, insbesondere von Kosmetik-, Lebens- oder Arzneimitteln, wobei der Begriff "Packgut" alle festen/flüssigen und/oder festen Stoffe umfassen kann und auch etwa eine zeitweise Zwischenlagerung und/oder ein Durchleiten insbesondere von medizinischen Flüssigkeiten, wie etwa Blut, umfasst.

Als mögliche Beschichtungsverfahren, die in der Vakuumkammer zur Anwendungen kommen, kommen insbesondere CVD (Chemical Vapour Deposition) Verfahren wie Plasma Enhanced Chemical Vapour Deposition (PECVD) und PVD (Physical Vapour Deposition) Verfahren wie Sputtern in Betracht.

Vorteilhaft schafft es die Erfindung die Nachteile einer Beschichtung an Siegelbereichen zu umgehen, indem vor dem Beschichten die zu beschichtenden Verpackungsformteile durch Maskiermittel mit mindestens einem Maskierkörper versehen werden, der so an den Verpackungsformteilen anliegt, dass er die Siegelbereiche so abdeckt, dass er während des Beschichtungsprozesses ein Ablagern einer Beschichtung an den maskierten Bereichen unterbindet.

Die Siegelzone ist der Bereich des Verpackungsformteils, der geeignet und bestimmt ist, mit einem Verschlussmittel, insbesondere einer Siegelfolie, durch ein Siegelmaterial, insbesondere Polyethylen oder Polypropylen, gesiegelt zu werden und der nach dem Siegeln nur unter Krafteinwirkung von den Verschlussmitteln ablösbar ist bzw. von dem das Verschlussmittel nach dem Siegeln nur unter Krafteinwirkung ablösbar ist. Die Siegelzone kann insbesondere auf der Außenseite, vorzugsweise an einem umlaufenden Siegelkragen bzw. Siegelrand des Verpackungsformteils, oder alternativ im Inneren des Verpackungsformteils, insbesondere zur Festlegung eines Verschluss- oder Trennmittels, vorgesehen werden und schließt bevorzugt umfangsgeschlossen einen Bereich, insbesondere eine Öffnung des Aufnahmebereichs ein. Auch ist es denkbar zusätzlich zu der ersten Siegelzone eine weitere Siegelzone an der Innen- oder Außenseite des Verpackungsformteils vorzusehen.

Das Siegelmaterial kann an dem Verschlussmittel aufgebracht sein und/oder vor dem Versiegelungsschritt gesondert auf die Siegelzone und/oder das Verschlussmittel aufgebracht werden. Als Siegelmaterial können gängige Siegelmaterialien, beispielsweise auf Basis von Polyethylen, Polypropylen und/oder Polyurethan zum Einsatz kommen.

Bevorzugt ist das Verpackungsformteil so hergestellt ist, dass die Siegelzone, insbesondere an der Innen- und/oder Außenseite des Verpackungsformteils, umfangsgeschlossen einen Bereich, insbesondere eine Öffnung der Kavität, bevorzugt als Öffnungsrand, einschließt. Hierdurch kann zum Beispiel der Aufnahmebereich durch Siegelung mit einer Siegelfolie hermetisch gegenüber der Umgebung versiegelt werden.

Bei einem CVD-Verfahren liegt der Maskierkörper beispielsweise so eng und dichtend an den Verpackungsformteilen an, dass die Beschichtungsgase nicht an die abgedeckten Bereiche (insbesondere die Siegelbereiche) gelangen können. Ein solcher Maskierkörper umfasst bevorzugt eine Abdichtung, bevorzugt aus einem Elastomer, insbesondere eine Gummierung und/oder eine Silikonabdichtung. Diese Abdichtung wird bevorzugt unter einer Gewichtskraft (und gegebenenfalls unter einer zusätzlichen Anpresskraft) gegen die Verpackungsformteile angepresst, um Zwischenräume zwischen der Abdichtung und den Verpackungsformteilen zu minimieren und eine hohe Dichtwirkung zu gewährleisten. Die Kontaktbereiche zwischen der Abdichtung und den Verpackungsformteilen sowie die von der Abdichtung hermetisch abgeschlossen Zwischenbereiche an den Verpackungsformteilen werden während des Beschichtens nicht beschichtet.

Bei einem PVD-Verfahren unterbindet der Maskierkörper beispielsweise ein Auftreffen des Elektronenstrahls auf die Oberfläche des Verpackungsformteils an definierten (abgedeckten) Stellen, wodurch diese Stellen bzw. Bereiche nicht beschichtet werden.

Dies bedeutet, dass von der Abstützfläche (zwischen Verpackungsformteil und dessen Unterlage) verschiedene Siegelbereiche durch die Abdeckung nicht beschichtet werden. Bevorzugt werden die Maskierkörper nach dem Anbringen der Verpackungsformteile auf oder in einer Trägereinheit an den Verpackungsformteilen angebracht, jedoch ist es auch denkbar diese Reihenfolge umzukehren.

Die Maskierkörper sind hierbei jeweils ein ein- oder mehrstückiger fester Körper, der am Stück (oder in Stücken) an die Verpackungsformteile angelegt und auch am Stück wieder von den Verpackungsformteilen entfernt werden kann, bevorzugt mechanisch. Insbesondere sind die Maskierkörper keine Lackschicht oder dergleichen, sodass kein aufwendiger Verarbeitungsschritt zum Entfernen der Lackschicht in einem Ablösevorgang benötigt wird. Die Maskierkörper werden durch Demaskiermittel ohne großen Aufwand nach dem Beschichten wieder von den Verpackungsformteilen abgenommen. Bevorzugt werden die Maskierkörper vor Entnahme der Verpackungsformteile aus der Trägereinheit von den Verpackungsformteilen entfernt, jedoch ist auch hier eine umgekehrte Reihenfolge denkbar. Hierbei kann ein Maskierkörper einem oder mehreren Verpackungsformteilen zugeordnet sein und bei diesen Verpackungsformteilen jeweils die Siegelbereiche abdecken. Vorzugsweise ist ein Maskierkörper für je eine Trägereinheit vorgesehen, wobei eine Trägereinheit einer Vielzahl von Verpackungsformteilen zugeordnet sein kann.

Werden beispielsweise Siegelbereiche von den Maskierkörpern abgedeckt, so werden diese nicht beschichtet und weisen somit die ursprünglichen Siegeleigenschaften der zu beschichtenden Verpackungsformteile auf. Zwar ist durch die fehlende Beschichtung an den Siegelbereichen die Gas- und/oder Feuchtigkeitssperrwirkung geringer als mit Beschichtung, jedoch nehmen diese Siegelbereiche meist nur einen unbedeutenden Teil an der Gesamtfläche ein und/oder befinden sich an Abschnitten der Verpackungsformteile, an denen eine Gas und/oder Feuchtigkeitswirkung mehr oder weniger irrelevant ist, beispielsweise die als Ringkragen einen Behälter umrandenden Siegelflächen.

Besonders vorteilhaft sind die Maskiermittel und die Demaskiermittel durch eine gemeinsame Einheit ausgebildet und bevorzugt werden die Maskierkörper jeweils direkt nach dem Entfernen von den beschichteten Verpackungsformteilen wieder zur Maskierung von zu beschichtenden Verpackungsformteile verwendet. Hier bietet sich beispielsweise ein Vakuumgreifarm an, der die Maskierkörper von der Demaskierposition zur Maskierposition übergibt. Hierdurch werden Zwischenlager für Maskierkörper nicht zwingend benötigt und es wird eine Wiederverwendbarkeit der Maskierköper gewährleistet, was ökonomische und ökologische Vorteile mit sich bringt. Auch ist es auch denkbar, zwischen den Maskiermitteln und den Demaskiermitteln etwa eine Reinigungseinheit für die Maskierkörper vorzusehen.

Für einen hohen Produktionsdurchsatz hat es sich als vorteilhaft herausgestellt, die Verpackungsformteile geometrisch linear (vorzugsweise translatorisch) durch die Beschichtungsmittel durchlaufen zu lassen, also den Transportweg so auszubilden, dass die Verpackungsformteile jeweils eine Position der Beschichtungsmittel nur einmal durchlaufen. Hierdurch wird eine durchlaufende Produktion ermöglicht und insbesondere gegenüber dem Drehteller aus dem Stand der Technik ein erhöhter Durchsatz ermöglicht, da zeitgleich Verpackungsformteile aus den Beschichtungsmitteln zu- und abgeführt werden können.

Bevorzugt umfassen die Beschichtungsmittel in Durchlaufrichtung (Transportrichtung) der Trägereinheiten zuerst eine Einlassschleuse, dann eine Vakuumkammer mit einer darauf folgenden Auslassschleuse. Durch den linearen Aufbau müssen die Schleusen und die Kammer nicht zeitlich aneinander synchronisiert sein, insbesondere können die Anzahl der Trägereinheiten in den jeweiligen Abschnitten und/oder die Verweildauer der einzelnen Trägereinheiten in den jeweiligen Abschnitten von einander abweichen.

Anlagentechnisch hat es sich als besonders vorteilhaft herausgestellt, wenn der Transportweg aus zwei Transportabschnitten besteht, die in zu einander parallelen und in um 180° zu einander gedrehten (also antiparallelen) Transportrichtungen verlaufen. Durch diese Rückführung können die Anlagen besonders kompakt ausgestaltet sein und somit wichtigen Produktionsraum einsparen. Hier ist es auch denkbar, auf diese Weise mehr als zwei Transportabschnitte vorzusehen, wobei ein dritter Transportabschnitt antiparallel zum zweiten Transportabschnitt ist, ein vierter Transportabschnitt antiparallel zum dritten Transportabschnitt ist, etc.

Insbesondere ist es vorteilhaft, wenn durch diese Rückführung die Maskierposition und die Demaskierungsposition räumlich nah sind, etwa sich die Maskierposition senkrecht zu einer Transportrichtung eines Transportabschnitts neben der Demaskierungsposition befindet. Hierdurch werden Übergabedistanzen für die Maskierkörper gering gehalten. Bevorzugt ist hierfür die Maskierungspostition dem ersten Transportabschnitt zugeordnet und die Demaskierposition dem zweiten Transportabschnitt zugeordnet.

Ähnlicherweise ist es vorteilhaft, wenn durch diese Rückführung die Zuführposition in die Vorrichtung und die Entnahmeposition räumlich nah sind, etwa sich die Zuführposition senkrecht zu einer Transportrichtung eines Transportabschnitts neben der Entnahmeposition befindet. Hierdurch lässt sich die Vorrichtung besonders gut als Blackbox in bereits bestehende Fertigungsprozesse einfügen. Bevorzugt ist hierfür die Zuführposition dem ersten Transportabschnitt zugeordnet und die Entnahmeposition dem zweiten Transportabschnitt zugeordnet.

Vorteilhaft sind den Zuführmitteln Formmittel vorgelagert, die die Verpackungsformteile etwa durch Spritzgießen, Spritzblasen (injection blowmolding), etc. formen. Hierdurch können unter anderem die Verpackungsformteile, die noch sehr sauber sind und somit eine Oberfläche haben, an der eine Beschichtung gut halten kann, beschichtet werden, wodurch beispielsweise eine Reinigung der Verpackungsformteile nicht zwingend nötig ist.

Da kürzlich geformte Verpackungsformteile eine erhöhte Temperatur aufweisen, sind den Beschichtungsmitteln bevorzugt Kühlmittel vorgelagert, die die Verpackungsformteile so abkühlen, dass ihre Temperatur bei Eintritt in die Vakuumkammer der Beschichtungsmittel unter zwischen 10°C und 45°C beträgt, insbesondere in einem Bereich von 30°C bis 45°C, besonders bevorzugt zwischen 20°C und 30°C. Die Eintrittstemperatur ist insbesondere in etwa auf der Auftragtemperatur des Beschichtungsmaterials, da ansonsten aufgrund von unterschiedlichen Temperatureigenschaften, etwa Risse oder Formverzerrungen auftreten können. Sobald die Temperatur ausreichend gesenkt wurde, sinkt auch die Schrumpfrate der Polymere der unbeschichteten Verpackungsformteile, sodass Spannungen und Spannungsrisse zwischen Polymer und Beschichtung vermieden werden

Um einen möglichst hohen und reibungslosen Durchsatz zu erzielen, sind die Durchlaufzeiten der Verpackungsformteile durch die Kühlmittel ein ganzzahliges Vielfaches der Durchlaufzeiten der Verpackungsformteile durch die Beschichtungsmittel, da hierdurch ein durchgängiger Inline-Fluss der Verpackungsformteile durch die Vorrichtung mit keinen (oder minimalen) Stillstandzeiten gewährleistet wird. Die Durchlaufzeiten der Verpackungsformteile durch die Beschichtungsmittel betragen bevorzugt weniger als 60 Sekunden, besonders bevorzugt weniger als 30 Sekunden.

Die Kühlmittel können die Verpackungsformteile mit einem Luft- und/oder Fluidstrom kühlend ausgebildet sein. Beispielsweise kann mittels eines Lüfters Wärme von den Verpackungsformteilen abgeführt werden.

Für eine besonders gleichmäßige Kühlung der Verpackungsformteile können die Kühlmittel auch durch eine Kühlkammer ausgebildet sein, die die Verpackungsformteile durchlaufen. Diese Kühlkammer kann die Wärmeenergie beispielsweise über ein gekühltes Gas (wie etwa Luft) und/oder gekühlte Flüssigkeiten (etwa in Form eines Kältebeckens) abführen.

Weiterhin ist es denkbar, dass die Kühlmittel zumindest teilweise durch die Transportmittel ausgebildet sind. So können die Kühlmittel durch verlängerte Bänder ausgebildet sind, die die Wärme selbst ableiten können und/oder bei denen die Wärmeenergie während des Transportes an die Umgebung (insbesondere die Umgebungsluft) abgegeben wird. Weiterhin können die Transportmittel selbst beispielsweise als gekühlte Metallkörper mit großem Flächenkontakt zu den Verpackungsformteilen als Kühlmittel ausgebildet sein.

Für eine Realisierung der Kühlmittel bietet sich insbesondere ein Paternoster an, also ein Transportabschnitt, bei dem die Trägereinheiten (und somit die Verpackungsformteile) unter einem Winkel zu einer Transportebene, insbesondere in vertikale Richtung, in Aufzugebenen nach oben befördert werden, dann einen Wendebereich durchlaufen und anschließend wieder unter einem Winkel zu der Transportebene, insbesondere in vertikale Richtung, vorzugsweise auf die vorherige Höhe zurück geführt werden. Hier ist es auch denkbar die Verpackungsformteile zeitweise von den Transportmitteln durch Belademittel des Paternosters zu entnehmen und durch Entlademittel des Paternosters nach dem Durchlauf wieder auf die Transportmittel anzubringen. Ein solcher Paternoster ermöglicht eine Kühlung durch Laufbandverlängerung mit einem minimalen Flächenaufwand für die Vorrichtung, da der Transport in vertikale Richtung erfolgt.

Für den Übergang von einem Transportabschnitt zum anderen können Übergabemittel vorgesehen sein, die die Trägereinheit übergeben. Solche Übergabemittel können beispielsweise durch einen Vakuumgreifarm oder andere Greifvorrichtungen, einen Druckschieber, Schienen, Rollen und/oder Laufbänder ausgebildet sein. Für einen besonders platzsparenden Aufbau erfolgt die Übergabe bevorzugt senkrecht zu den Transportrichtungen.

Als Material für die Verpackungsformteile kommen insbesondere Polyethylen (PE), Polypropylen (PP), Cycloolefincopolymer (COC), Cycloolefinpolymer (COP), Polyvinylchlorid (PVC), Polyethylenterephthalat (PET) oder Polyamid (PA) in Betracht.

Auch ist es denkbar, dass die Verpackungsformteile aus kompostierbaren Polymeren, insbesondere auf erneuerbaren Rohstoffen basierenden Polymeren, wie auf Stärke basierende Polymere (stark blends), PLA (Polyactid), Polyester des Typs PHA (Polyhydroxyalcanoat), z.B. PHB (Polyhydroxybutyrat), PHV (Polyhydroxyvaleat), Cellulosematerialien aus chemisch modifizierter Cellulose hergestellte Materialien, auf erneuerbaren Rohstoffen basierende Polymere sind insbesondere spezifische Polyester, z.B. auf PDO (Bio-Propandiol) basierend, spezifische Polyamide, z.B. aus Rizinusöl hergestellt, sowie Polyethylen (PE), Polypropylen (PP), Polyvinylchlorid (PVC) auf Bio-Ethanol aus z.B. Zuckerrohr basierend, sowie spezifische, aus Rohöl oder natürlichem Gas hergestellte synthetische Polyester, oder aus den genannten Werkstoffen hergestellten Laminaten geformt sind.

Als Beschichtungen insbesondere für Spritzgussteile hat sich eine Vakuumbeschichtung mit Metalloxiden, insbesondere Aluminiumoxiden, oder Siliziumoxiden wegen ihren guten Durchtrittssperrwirkungen, auch in dünnen Schichten, als zielführend herausgestellt.

Vorteilhaft sind die Beschichtungsmittel so ausgebildet, dass sie die Vakuumbeschichtung mittels eines Sputterverfahrens als oxidische, nitridische oder sulfidische Schicht aufträgt.

Auch kann mittels eines Plasma-CVD, bevorzugt einem PECVD (Plasma Enhanced Chemical Vapour Disposition) Verfahren mit HMDSO (Hexamethyldisiloxan) oder TEOS (Tetraethoxysilan), insbesondere mit Plasma-Vorbehandlung mit HMDSO und Sauerstoff, HMDSO und Stickstoff eine keramische Schicht als Beschichtung aufgetragen werden.

Weiter vorteilhaft sind die Beschichtungsmittel so ausgebildet, dass sie eine Vakuumbeschichtung durch Sputtern oder Verdampfen insbesondere von Metalloxiden, insbesondere Aluminiumoxiden, oder Siliziumoxiden, insbesondere SiOx, wobei x eine Zahl kleiner 2 bevorzugt kleiner 0,9 ist, oder durch Plasmapolymerisation von Siliziumoxiden, bevorzugt ausgehend von Organosilanen, insbesondere von Hexamethyldisiloxan (HMDSO) und Tetramethyldisiloxan (TMDSO) oder durch Plasmapolymerisation von hochvernetzten Kohlenwasserstoffschichten, insbesondere ausgehend von Methan, Ethylen oder Acetylen auf die Verpackungsformteile aufbringen.

Vorteilhaft können die Beschichtungsmittel auch so ausgebildet sein, dass die Beschichtung eine Kohlenstoffschicht ist, insbesondere eine amorphe Kohlenstoffschicht (englisch "diamond-like carbon" bzw. DLC).

Es bieten sich insbesondere folgende amorphe Kohlenstoffschichten an, die nach der Richtlinie VDI 2840 wie folgt unterteilt sind:
- Wasserstofffreie amorphe Kohlenstoffschichten "a-C" bestehen überwiegend aus sp²-hybridisierten Bindungen und werden deshalb auch als Graphitartige Kohlenstoffschichten bezeichnet.
- Tetraedrische wasserstofffreie amorphe Kohlenstoffschichten "ta-C" bestehen aus sp³-hybridisierten Bindungen, weshalb sie den Diamantschichten gleichzusetzen sind.
- Metallhaltige wasserstofffreie amorphe Kohlenstoffschichten, "a-C:Me"
- Wasserstoffhaltige amorphe Kohlenstoffschichten, "a-C:H" (H-Anteil > 35%)
- Tetraedrische wasserstoffhaltige amorphe Kohlenstoffschichten, "ta-C:H" (H-Anteil >25%) mit überwiegend sp³-hybridisierten Kohlenstoffatomen
- Metallhaltige wasserstoffhaltige amorphe Kohlenstoffschichten, "a-C:H:Me". Durch Dotieren mit Metallen bildet sich ein Verbund aus einer "a-C:H" Matrix und Metallkarbiden. Schichten aus diesem Material besitzen hohe Verschleißfestigkeiten, geringe Reibkoeffizienten sowie bessere Haftung der Schichten. Durch Veränderung des Metallgehaltes lassen sich die Materialeigenschaften stark beeinflussen.
- Modifizierte wasserstoffhaltige amorphe Kohlenstoffschichten, "a-C:H:X". Durch Dotierung mit Elementen wie Si, O, N, F und B können amorphe Kohlenstoffschichten je nach gewünschten Eigenschaften stark modifiziert werden. Silizium beispielsweise erhöht die Temperaturbeständigkeit in sauerstoffhaltiger Umgebung. Eine Dotierung mit Silizium und Sauerstoff kann die Oberflächenspannung stark herabsetzen (bis hin zu Werten in der Größenordnung von PTFE). Außerdem lassen sich transparente und äußerst kratzfeste Schichten herstellen.

Insbesondere für die Aufnahme von medizinischen und/oder biologischen Materialien, insbesondere Flüssigkeiten, bietet sich eine, bevorzugt fluoridierte, Kohlenstoffschicht an, da hierdurch unter anderem durch die gute Abbaubarkeit im Körper eine hohe biologische Verträglichkeit gegeben ist. Hier sei angemerkt, dass die Aufnahme auch lediglich kurzzeitig erfolgen kann, beispielsweise in einem Blutbeutel und/oder einer Durchflusskanüle.

Auch bei der Aufnahme von Lebensmitteln können durch die Beschichtung mit Kohlenstoffschichten die Vorteile der hohen biologischen Verträglichkeit mit einer erhöhten Durchtrittssperrwirkung gegen Gase und/oder Feuchtigkeit vereint werden.

Insgesamt schafft es die Erfindung auf besonders vorteilhafte Weise, die Nachteile einer (in anderen Bereichen gewünschten) Beschichtung für Siegelbereiche gezielt zu umgehen. Diese Siegelbereiche können beliebige Formen und Größen aufweisen, sodass sich auch schwer lokal beschränkbare Beschichtungsverfahren, wie insbesondere CVD-Verfahren, für Formen anwenden lassen, die ansonsten aufgrund der ungewollten Beschichtung von Siegelbereichen unpraktikabel wären und dies ohne zusätzliche Überlackschichten, die unter anderem die Dicke der resultierenden beschichteten Verpackungsformteile negativ beeinflussen und durch Materialkosten die Stückpreise erhöhen. Auch ermöglicht die Vorrichtung durch ihren linearen Aufbau einen erhöhten Durchsatz gegenüber zyklischen Aufbauten. Weiterhin wird durch die Ausgestaltung des Transportweges ein besonders kompakter Aufbau ermöglicht, der in vielen Produktionsstätten kostbaren Raum zur Verfügung stellen kann. Durch die nahe Anordnung von Zufuhr- und Entnahmeposition lässt sich die Vorrichtung auch leicht in bereits bestehende Produktionsprozesse einbinden.

Weitere Vorteile, Merkmale und Einzelheiten der Erfindung ergeben sich aus der nachfolgenden Beschreibung bevorzugter Ausführungsbeispiele sowie anhand der Zeichnungen.

Es zeigen:
- Fig. 1: eine schematische Darstellung einer ersten Vorrichtung zum Beschichten,
- Fig. 2: eine schematische Darstellung einer zweiten Vorrichtung zum Beschichten, mit Abkühlmitteln, Qualitätskontrollmittel und vorgelagerten Formmitteln,
- Fig. 3a: ein erstes Ausführungsbeispiel eines Maskierkörpers zur Maskierung der Ringkragenfläche eines Joghurt-Bechers in einer Untenansicht,
- Fig. 3b: das erste Ausführungsbeispiel eines Maskierkörpers zur Maskierung der Ringkragenfläche eines Joghurt-Bechers in einer Schnittansicht,
- Fig. 3c: ein mit dem ersten Ausführungsbeispiel eines Maskierkörpers maskierter Joghurt-Becher in einer Schnittansicht,
- Fig. 4a: ein zweites Ausführungsbeispiel eines Maskierkörpers zur Maskierung der Ringkragenfläche eines Joghurt-Bechers in einer Untenansicht,
- Fig. 4b: das zweite Ausführungsbeispiel eines Maskierkörpers zur Maskierung der Ringkragenfläche eines Joghurt-Bechers in einer Schnittansicht,
- Fig. 4c: ein mit dem zweiten Ausführungsbeispiel eines Maskierkörpers maskierter Joghurt-Becher in einer Schnittansicht.

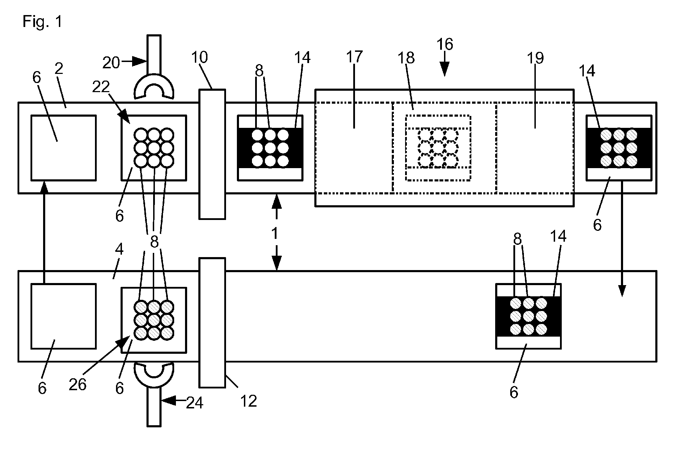

Fig. 1 zeigt eine schematische Darstellung eines ersten Ausführungsbeispiels einer Vorrichtung zum Beschichten von Verpackungsformteilen. Die Vorrichtung umfasst Transportmittel 1 mit einem ersten und einem zweiten Transportabschnitt 2 und 4, ausgebildet durch zwei Fließbänder. Auf den Fließbändern werden Trägereinheiten 6 befördert. In diesen Trägereinheiten 6 befinden sich, zumindest abschnittsweise, Verpackungsformteile 8, die durch die Zuführmittel 20 und die Entnahmemittel 24 in die Trägereinheiten 6 hinein bzw. aus den Trägereinheiten 6 hinaus befördert werden können. Die Zuführmittel 20 und die Entnahmemittel 24 sind hier durch einen Greifarm, insbesondere mit Saugnäpfen, dargestellt.

Weiterhin weist die Vorrichtung Maskiermittel 10 und Demaskiermittel 12 auf, an denen Maskierkörper 14 an die Verpackungsformteile angebracht werden (im Falle der Maskiermittel 10) bzw. von diesen entfernt werden (im Falle der Demaskiermittel 12).

Auch weist die Vorrichtung Beschichtungsmittel 16 auf dem ersten Transportabschnitt 2 auf, die eine Einlassschleuse 17, eine Vakuumkammer 18 und eine Auslassschleuse 19 umfassen.

Zum Beschichten von Verpackungsformteilen 8 werden die zu beschichtenden Verpackungsteile 8 durch die Zuführmittel 20 der Vorrichtung in einer Zuführposition 22 zugeführt. Die Zuführmittel 20 platzieren die Verpackungsteile direkt in Trägereinheiten 6, die wiederum durch Transportmittel, hier ausgebildet durch ein erstes und ein zweites Förderband 2 und 4, auf einem Transportweg geführt werden.

Der Transportweg setzt sich hier aus zwei gleich langen Teilabschnitten zusammen, die zu einander parallel sind und in um 180° zueinander gedrehte Richtungen, d.h. entgegengesetzt, verlaufen, wobei der erste Teilabschnitt dem ersten Förderband zugeordnet ist und der zweite Teilabschnitt dem zweiten Förderband zugeordnet ist.

Auf dem Transportweg durchlaufen die Trägereinheiten 6 (und somit die Verpackungsformteile 8) zunächst eine Maskierposition, in der die Verpackungsformteile 8 mit Maskierkörpern 14 versehen werden. Durch die Kontaktflächen (insbesondere die Auflageflächen) der Verpackungsformteile mit den Trägereinheiten werden bereits diese Kontaktflächen (und gegebenenfalls durch diese Kontaktflächen abgeschlossenen Bereiche) nicht beschichtet. Die Maskierkörper 14 decken nun zusätzlich Bereiche der Verpackungsformteile 8 ab, die ansonsten in dem folgenden Beschichtungsvorgang beschichtet werden würden. Die abgedeckten Bereiche sind hier Siegelbereiche, an denen die durch die Beschichtung nur eine ungenügende Siegelfähigkeit und somit ein unzureichender Halt der Siegelfolie gegeben wäre.

Auf dem Transportweg gelangen die Trägereinheiten 6 nun in die Beschichtungsmittel 16. Zunächst wird ihr Umgebungsdruck in der Einlassschleuse 17 auf den Druck der Vakuumkammer 18 angepasst. In der Vakuumkammer wird nun mittels eine PECVD-Verfahrens eine Siliziumoxidschicht aufgebracht, welche in der Zeichnung durch die Schraffur der entsprechenden Verpackungsformteile 8. Anschließend wird in der Auslassschleuse 19 der Umgebungsdruck der Trägereinheiten 6 wieder an den Aussendruck außerhalb der Beschichtungsmittel 16 angepasst.

Die Trägereinheiten 6 wechseln nun durch nicht dargestellte erste Übergabemittel vom ersten Transportabschnitt (dem ersten Förderband 2) auf den zweiten Transportabschnitt (das zweite Förderband 4).

Hier werden die Maskierkörper 14 wieder von den Trägereinheiten 6 entfernt und anschließend die beschichteten Verpackungsformteile 8 durch Entnahmemittel 24 aus den Trägereinheiten 6 entnommen. Die beschichteten Verpackungsformteile können nun befüllt, versiegelt und gegebenenfalls sterilisiert werden.

Die leeren Trägereinheiten 6 werden durch nicht dargestellte zweite Übergabemittel vom zweiten Transportabschnitt wieder auf den ersten Transportabschnitt zurück geführt.

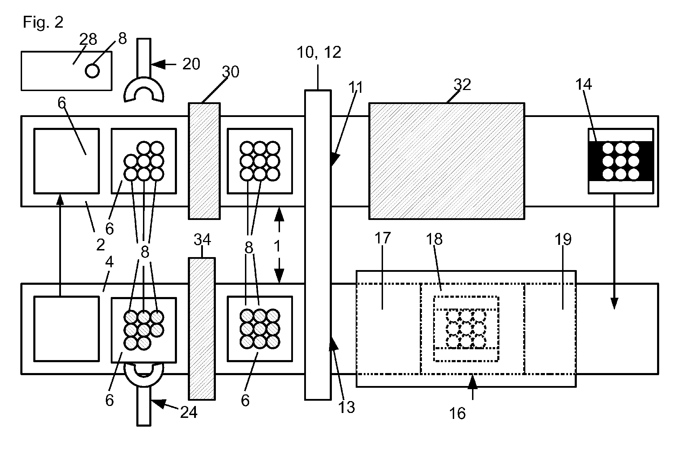

In Fig. 2 ist ein zweites Ausführungsbeispiel einer Vorrichtung zum Beschichten von Verpackungsformteilen schematisch dargestellt. Die Vorrichtung umfasst Transportmittel 1 mit einem ersten und einem zweiten Transportabschnitt 2 und 4, ausgebildet durch zwei Fließbänder. Auf den Fließbändern werden Trägereinheiten 6 befördert. In diesen Trägereinheiten 6 befinden sich, zumindest abschnittsweise, Verpackungsformteile 8, die durch die Zuführmittel 20 und die Entnahmemittel 24 in die Trägereinheiten 6 hinein bzw. aus den Trägereinheiten 6 hinaus befördert werden können. Die Zuführmittel 20 und die Entnahmemittel 24 sind hier durch einen Greifarm dargestellt.

Im Gegensatz zu dem Ausführungsbeispiel in Fig. 1 sind hier die Maskiermittel 10 und Demaskiermittel 12 durch eine gemeinsame Einheit ausgebildet. Diese gemeinsame Einheit bringt die Maskierkörper 14 an die Verpackungsformteile 8 in der Maskierposition 11 an und entnimmt die Maskierkörper 14 in der Demaskierposition 13. Die Maskierposition 11 und die Demaskierposition 14 liegen nahe bei einander und befinden sich senkrecht zur Transportrichtung auf einer Linie, wodurch die gemeinsame Einheit zum Maskieren und Demaskieren die Maskierkörper mit wenig Aufwand von der Maskierposition 11 zur Demaskierposition 14 befördern kann, wo sie möglichst unmittelbar wieder zum Maskieren von Verpackungsformteilen 8 verwendet werden.

Auch weist die Vorrichtung Beschichtungsmittel 16 auf, die sich in diesem Ausführungsbeispiel auf dem zweiten Transportabschnitt 4 befinden. Die Beschichtungsmittel 16 umfassen eine Einlassschleuse 17, eine Vakuumkammer 18 und eine Auslassschleuse 19.

Die Vorrichtung umfasst Formmittel 8, die in an sich bekannter Weise Verpackungsformteile 8 in Form von Spritzgussteilen aus einem Kunststoff formen. Diese Verpackungsformteile 8 werden durch die Zuführmittel 20 in der Zuführposition 22 auf eine der Trägereinheiten 6 aufgelegt.

Da die Verpackungsformteile 8 durch den Formprozess in den Formmitteln 28 noch eine hohe Temperatur haben, werden die Verpackungsformteile 8 durch Kühlmittel 30 zunächst gekühlt. Ziel dieser Abkühlung ist es, eine Temperatur der Verpackungsformteile 8 bei Eintritt in die Beschichtungsmittel von unter 45°C zu erreichen. Sind nämlich die Verpackungsformteile 8 während des Beschichtungsvorgangs wesentlich wärmer als die aufgetragene Beschichtung, so kommt es bei einer darauffolgenden Abkühlung (etwa durch Lagerung, Transport oder auch eine zusätzliche aktive Kühlung) aufgrund der unterschiedlichen Temperatureigenschaften von Verpackungsformteil 8 und Beschichtung beispielsweise durch den abweichenden Ausdehnungskoeffizienten zu Rissen in der Beschichtung, wodurch wiederum die gewünschten Barriereeigenschaften (die Durchtrittssperrwirkung) reduziert werden.

In diesem Ausführungsbeispiel sind den Beschichtungsmitteln auf dem Transportweg fakultative Vorbehandlungsmittel 32 vorgelagert, welche die Verpackungsteile 8 (und gegebenenfalls auch die Trägereinheiten 6) für den eigentlichen Beschichtungsvorgang vorbereiten etwa durch Säubern, Priming und dergleichen.

Nach dem Beschichten in den Beschichtungsmitteln werden die Maskierkörper 14 von den Verpackungsteilen 8 entfernt und auf oben genannte Weise wieder verwendet.

Die nun beschichteten Verpackungsteile 8 durchlaufen nun Qualitätskontrollmittel 34, die die Qualität der beschichteten Verpackungsteile 8, insbesondere der Beschichtung, überprüfen, eine entsprechende Bewertung festhalten und/oder einer Kontrolleinheit übermitteln können und auch solche Verpackungsteile 8 aussondern können, die nicht festgelegten Qualitätsstandards entsprechen.

Nach der Qualitätskontrolle werden die Verpackungsformteile 8 durch die Entnahmemittel 24 von der Trägereinheit 6 entnommen und für eine weitere Verarbeitung weiter gegeben.

Die genaue Reihenfolge des Durchlaufens der Kühlmittel 30, der Maskier- und Demaskierposition 11 bzw. 13, der Vorbehandlungsmittel 32 und der Qualitätskontrollmittel 34 auf dem Transportweg kann ausgetauscht werden, wesentlich ist, dass die Maskierposition 11 vor den Beschichtungsmitteln 16, die Demaskierposition 13 nach den Beschichtungsmitteln 16, die Kühlmittel 30 vor den Beschichtungsmitteln 16, die Vorbehandlungsmittel 30 vor den Beschichtungsmitteln 16 sowie die Qualitätskontrollmittel 30 nach den Beschichtungsmitteln 16 durchlaufen werden.

Ergänzend sei erwähnt, dass hier die Trägereinheiten stets getrennt von den Transportmitteln beschrieben wurden, diese können jedoch auch zusammen fallen, beispielsweise wenn die Verpackungsformteile direkt auf ein Förderband aufgebracht werden oder etwa wenn die Trägereinheiten durch selbstangetriebene Einheiten ausgebildet sind.

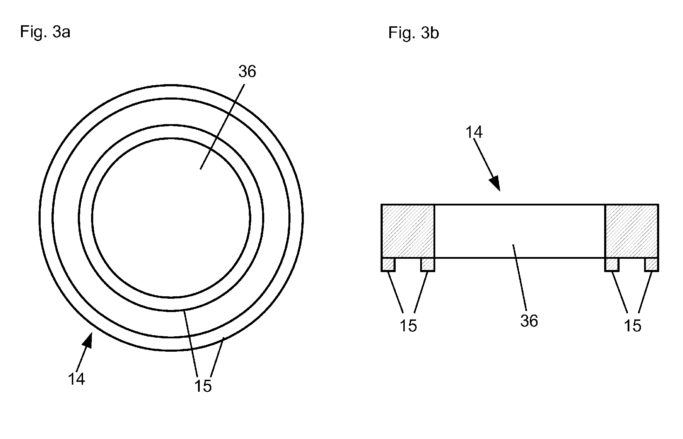

Fig. 3a zeigt beispielhaft in einer Untenansicht ein erstes Ausführungsbeispiel eines Maskierkörpers 14 zur Maskierung von Siegelbereichen, hier Ringkragenflächen 39 von als Joghurtbecher 38 ausgebildeten Verpackungsformteilen 8, die in einem auf die Beschichtung folgenden Verarbeitungsschritt mit einer Siegelfolie versiegelt werden. Fig. 3b zeigt den selben Maskierkörper 14 in einem Querschnitt.

Der Maskierkörper 14 ist hier ein Ringkörper, bei dem an einer Unterseite am inneren radialen Rand sowie am äußeren radialen Rand Abdichtungsmittel 15 vorgesehen sind. Die Abdichtungsmittel 15 sind aus einem Elastomer, bevorzugt aus Silikon oder einer Gummierung. Innerhalb des Rings ist ein freigelassener Raum 36, der somit hoch gasdurchlässig ist.

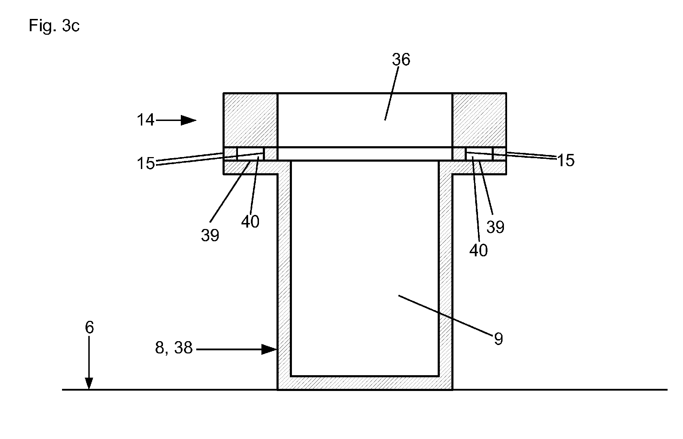

In Fig. 3c wird der Maskierkörper 14 aus Fig. 3a bzw. 3b durch Maskiermittel 10 an ein als Joghurtbecher 38 ausgebildetes Verpackungsformteil 8, angebracht, d.h. der Joghurtbecher 38 wird mit dem Maskierkörper 14 maskiert. Der Joghurtbecher 38 befindet sich auf einer Trägereinheit 6.

Die Abdichtungsmittel 15 liegen an den Ringkragenflächen 39 des Joghurtbechers 38 an. Zwischen den Abdichtungsmitteln 15, den Ringkragenflächen 39 und dem Maskierkörper 14 bildet sich ein hermetisch abgeschlossener Raum 40.

Wird der mit dem Maskierkörper 14 maskierte Joghurtbecher 38 in der Vakuumkammer 18 der Beschichtungsmittel 16 nun beispielsweise in einem CVD-Verfahren beschichtet, so werden die Kontaktflächen zwischen dem Joghurtbecher 38 und der Trägereinheit 6 nicht beschichtet, da die Gase nicht an sie gelangen. Zusätzlich wird durch den Maskierkörper 14 sowohl der hermetisch abgeschlossene Raum 40 als auch die Kontaktflächen zwischen Abdichtungsmitteln 15 und den Ringkragenflächen 39 nicht beschichtet, da die Gase nicht an sie gelangen können.

Vorteilhaft an diesem Ausführungsbeispiel ist, dass durch den freigelassenen Raum 36 die Beschichtungsgase an die Oberflächen des Aufnahmebereichs 9 (hier der Innenraum des Joghurtbechers) gelangen können und diese somit beschichtet werden. Bei herkömmlichen CVD-Verfahren des Standes der Technik würden entweder die Ringkragenflächen 39 und auch die Oberflächen des Aufnahmebereichs 9 beschichtet werden, oder aber der Joghurtbecher 38 würde mit den Ringkragenflächen auf der Trägereinheit 6 aufliegen, sodass weder die Ringkragenflächen noch der von den Ringkragenflächen (undefiniert) hermetisch abgeschlossene Innenraum des Joghurtbechers beschichtet werden würden.

Bei einem herkömmlichen PVD-Verfahren des Standes der Technik wäre ebenfalls die Oberfläche des Aufnahmebereichs 9 (also der Innenraum des Joghurtbechers) durch den Elektronenstrahl an den verwinkelten Stellen nur schwer erreichbar, wodurch dort eine nur ungenügende Beschichtung erreichbar ist.

Das Ausführungsbeispiel ermöglicht somit eine Art der Beschichtung, die mit herkömmlichen Verfahren nicht erreichbar wäre.

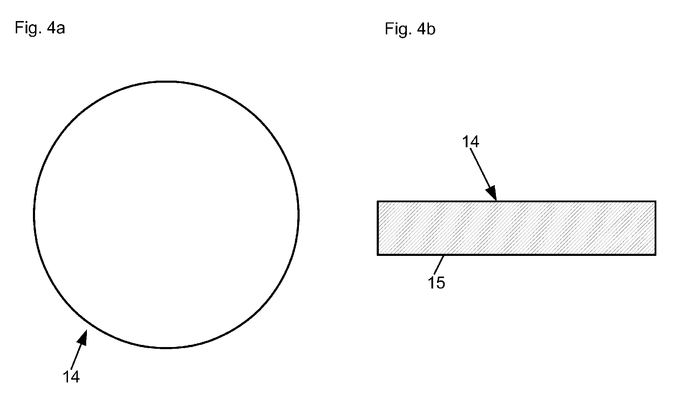

Fig. 4a zeigt beispielhaft in einer Untenansicht ein zweites Ausführungsbeispiel eines Maskierkörpers 14 zur Maskierung von Siegelbereichen, hier Ringkragenflächen 39 von als Joghurtbecher 38 ausgebildeten Verpackungsformteilen 8, die in einem auf die Beschichtung folgenden Verarbeitungsschritt mit einer Siegelfolie versiegelt werden. Fig. 4b zeigt den selben Maskierkörper 14 in einem Querschnitt. Der Maskierkörper 14 ist hier im Wesentlichen scheibenförmig.

Im Gegensatz zu dem in den Figuren 3a bis 3c dargestellten Maskierkörper 14 besteht der Maskierkörper 14 hier vollständig aus den Abdichtungsmitteln 15.

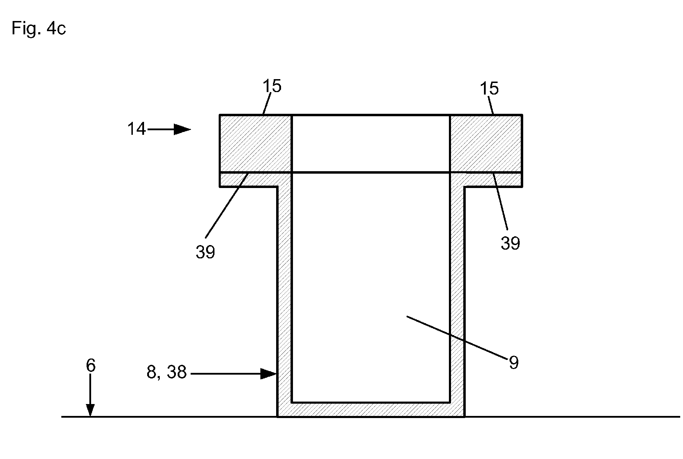

In Fig. 4c ist ein mit dem Maskierkörper aus den Figuren 4a bzw. 4b maskierter Joghurtbecher 38 dargestellt, der auf einer Trägereinheit 6 angeordnet ist.

Wird der Joghurtbecher etwa in einem CVD-Verfahren beschichtet, so wird lediglich die Außenfläche des Joghurtbechers beschichtet. Sowohl die Kontaktflächen zwischen Joghurtbecher 38 und der Trägereinheit 6, die Kontaktflächen zwischen Abdichtungsmitteln 15 und den Siegelbereichen 39 wie auch der Aufnahmebereich 9 des Joghurtbechers 38 werden nicht beschichtet, da die erforderlichen Beschichtungsgase nicht an sie gelangen können.

Wird eine Beschichtung der Oberfläche des Aufnahmebereichs 9 gewünscht, so kann der Maskierkörper 14 an den gestrichelt dargestellten Linien ausgespart werden, sodass die Beschichtungsgase in den Aufnahmebereich 9 gelangen können und somit die Oberfläche des Aufnahmebereichs 9 beschichtet wird.

### Bezugszeichen:

- 1: Transportmittel
- 2: erstes Förderband
- 4: zweites Förderband
- 6: Trägereinheit
- 8: Verpackungsformteil
- 9: Aufnahmebereich
- 10: Maskiermittel
- 11: Maskierposition
- 12: Demaskiermittel
- 13: Demaskierposition
- 14: Maskierkörper
- 15: Abdichtungsmittel
- 16: Beschichtungsmittel
- 17: Einlassschleuse
- 18: Vakuumkammer
- 19: Auslassschleuse
- 20: Zuführmittel
- 22: Zuführposition
- 24: Entnahmemittel
- 26: Entnahmeposition
- 28: Formmittel
- 30: Kühlmittel
- 32: Vorbehandlungsmittel
- 34: Qualitätskontrollmittel
- 36: freigelassener Raum
- 38: Joghurtbecher
- 39: Ringkragenflächen des Joghurtbechers
- 40: hermetisch abgeschlossener Raum

## Patentansprüche

1. Vorrichtung zum Beschichten von durch Spritzgießen, Spritzblasen Blasformen und/oder Tiefziehen hergestellten Verpackungsformteilen (8) mit einem Aufnahmebereich (9) zur Aufnahme von Packgut, insbesondere von Kosmetik-, Lebens- oder Arzneimitteln, umfassend
Zuführmittel (20) zum Zuführen von zu beschichtenden Verpackungsformteilen (8) in eine Zuführposition (22),
Entnahmemittel (24) zum Entnehmen von beschichteten Verpackungsformteilen (8) aus einer Entnahmeposition (26),
mindestens eine Trägereinheit (6) zum Tragen der Verpackungsformteile (8),
Transportmittel zum Transport der mindestens einen Trägereinheit (6) von der Zuführposition (20) zur Entnahmeposition (26) auf einem Transportweg,
Beschichtungsmittel (16) umfassend eine Vakuumkammer (18), die so ausgebildet sind, dass sie die zu beschichtenden Verpackungsformteile (8) mit einer Vakuumbeschichtung zum Erhöhen der Durchtrittssperrwirkung gegen Gase und/oder Feuchtigkeit, insbesondere Wasserdampf, beschichten,
**dadurch gekennzeichnet,**
**dass** auf dem Transportweg Maskiermittel (10) vorgesehen sind, die so ausgebildet sind, dass sie die zu beschichtenden Verpackungsformteile (8) vor Eintritt in die Beschichtungsmittel (16) in einer Maskierposition (11) mit mindestens einem Maskierkörper (14) maskieren, der ein Beschichten von Siegelbereichen der Verpackungsformteile (8) unterbindet,
sowie dass auf dem Transportweg Demaskiermittel (12) vorgesehen sind, die von den beschichteten Verpackungsformteile (8) den mindestens einen Maskierkörper (14) nach Austritt aus den Beschichtungsmitteln (16) in einer Demaskierposition (13) wieder entfernen.

2. Vorrichtung nach Anspruch 1,
**dadurch gekennzeichnet,**
**dass** die Maskiermittel (10) und die Demaskiermittel (12) durch eine gemeinsame Einheit realisiert sind, welche so ausgebildet ist, dass sie den von den beschichteten Verpackungsformteilen (8) entfernten mindestens einen Maskierkörper (14) unmittelbar von der Demaskierposition (13) zur Maskierposition (11) transferieren und dort mit diesem Maskierkörper (14) zu beschichtende Verpackungsformteile (8) maskieren.

3. Vorrichtung nach Anspruch 1 oder 2,
**dadurch gekennzeichnet,**
**dass** die Transportmittel so ausgebildet sind, dass sie die Verpackungsformteile (8) linear durch die Beschichtungsmittel (16) führen.

4. Vorrichtung nach einem der Ansprüche 1 bis 3,
**dadurch gekennzeichnet,**
**dass** der Transportweg einen ersten und einen zweiten linearen Transportabschnitt (2 bzw. 4) umfasst, wobei die Transportrichtungen des ersten und des zweiten Transportabschnitts (2 bzw. 4) zueinander antiparallel verlaufen.

5. Vorrichtung nach Anspruch 4,
**dadurch gekennzeichnet,**
**dass** erste Übergabemittel vorgesehen sind, die die mindestens eine Trägereinheit (6) vom ersten zum zweiten Transportabschnitt (2 bzw. 4) übergeben, vorzugsweise senkrecht zur Transportrichtung des ersten und des zweiten Transportabschnitts (2 bzw. 4).

6. Vorrichtung nach Anspruch 4 oder 5,
**dadurch gekennzeichnet,**
**dass** zweite Übergabemittel vorgesehen sind, die die mindestens eine Trägereinheit (6) vom zweiten zum ersten Transportabschnitt (4 bzw. 2) übergeben, vorzugsweise senkrecht zur Transportrichtung des ersten und des zweiten Transportabschnitts (2 bzw. 4).

7. Vorrichtung einem der Ansprüche 4 bis 6,
**dadurch gekennzeichnet,**
**dass** die Zuführposition (22) und die Maskierposition (11) dem ersten Transportabschnitt (2) zugeordnet sind sowie dass die Entnahmeposition (26) und die Demaskierposition (13) dem zweiten Transportabschnitt (4) zugeordnet sind.

8. Vorrichtung nach einem der Ansprüche 1 bis 7,
**dadurch gekennzeichnet,**
**dass** die Beschichtungsmittel (16) eine Vakuumkammer (18) sowie eine der Vakuumkammer (18) in Transportrichtung der Transportmittel vorgelagerte Einlassschleuse (17) und eine der Vakuumkammer in Transportrichtung der Transportmittel nachgelagerte Auslassschleuse aufweisen (19).

9. Vorrichtung nach einem der Ansprüche 1 bis 8,
**dadurch gekennzeichnet,**
**dass** den Zuführmitteln (20) Formmittel (28) vorgelagert sind, die die zu beschichtenden Verpackungsformteile durch Spritzgießen, Spritzblasen, Blasformen und/oder Tiefziehen formen.

10. Vorrichtung nach einem der Ansprüche 1 bis 9,
**dadurch gekennzeichnet,**
**dass** den Beschichtungsmitteln (16) auf dem Transportweg vorgelagerte Kühlmittel (30) vorgesehen sind, die so ausgebildet sind, dass sie die Verpackungsformteile (8) so herabkühlen, dass sie bei Eintritt in die Vakuumkammer (18) der Beschichtungsmittel (16) eine Temperatur unter 45 °C, insbesondere zwischen 20 °C und 35 °C aufweisen.

11. Vorrichtung nach einem der Ansprüche 1 bis 10,
**dadurch gekennzeichnet,**
**dass** die Beschichtungsmittel (16) so ausgebildet sind, dass sie die Vakuumbeschichtung mittels Plasma-CVD, bevorzugt einem PECVD (Plasma Enhanced Chemical Vapour Disposition) mit HMDSO (Hexamethyldisiloxan) oder TEOS (Tetraethoxysilan), insbesondere mit Plasma-Vorbehandlung mit HMDSO und Sauerstoff, HMDSO und Stickstoff als keramische Schicht aufträgt.

12. Vorrichtung nach einem der Ansprüche 1 bis 11,
**dadurch gekennzeichnet,**
**dass** die Beschichtungsmittel (16) so ausgebildet sind, dass sie Vakuumbeschichtung durch Sputtern oder Verdampfen insbesondere von Metalloxiden, insbesondere Aluminiumoxiden, oder Siliziumoxiden, insbesondere SiOx, wobei x vorzugsweise eine Zahl kleiner 2 bevorzugt kleiner 0,9 ist, oder durch Plasmapolymerisation von Siliziumoxiden, bevorzugt ausgehend von Organosilanen, insbesondere von Hexamethyldisiloxan (HMDSO) und Tetramethyldisiloxan (TMDSO) oder durch Plasmapolymerisation von hochvernetzten Kohlenwasserstoffschichten, insbesondere ausgehend von Methan, Ethylen oder Acetylen auf die Verpackungsformteile (8) aufbringen.

13. Verfahren zur Beschichtung von durch Spritzgießen, Spritzblasen, Blasformen und/oder Tiefziehen hergestellten Verpackungsformteilen (8) mit einem Aufnahmebereich zur Aufnahme von Packgut, insbesondere Kosmetik-, Lebens- oder Arzneimitteln und mit einer Vakuumbeschichtung, insbesondere mit einer Vorrichtung nach einem der Ansprüche 1 bis 13, wobei zu beschichtende Verpackungsformteile (8) durch Zuführmittel (20) in einer Zuführposition (22) in mindestens einer Trägereinheit platziert werden, diese mindestens eine Trägereinheit (6) auf einem Transportweg durch Beschichtungsmittel (16) hindurch transportiert wird, wo die Verpackungsformteile (8) mit einer Vakuumbeschichtung beschichtet werden, und schließlich in einer Entnahmeposition (26) aus der mindestens einen Trägereinheit (6) entnommen werden,
**dadurch gekennzeichnet,**
**dass** die Verpackungsformteile (8) vor dem Beschichten mit mindestens einem Maskierkörper (14) maskiert werden, der ein Beschichten von Siegelbereichen der Verpackungsformteile (8) unterbindet und dass der mindestens eine Maskierkörper (14) nach dem Beschichten vom Verpackungsformteil (8) entfernt wird.

14. Verfahren nach Anspruch 13,
**dadurch gekennzeichnet,**
**dass** der Transportweg zwei antiparallele lineare Teilabschnitte (2, 4) umfasst, die bevorzugt gleich lang sind, und dass die mindestens eine Trägereinheit (6) auf einem dieser Teilabschnitte linear durch die Beschichtungsmittel (16) hindurch transportiert wird.

15. Verfahren nach Anspruch 13 oder 14,
**dadurch gekennzeichnet,**
**dass** die Verpackungsformteile (8) sich während des Transports, insbesondere während dem Beschichten, sich von den Trägermitteln über Abstützflächenbereiche abstützen und der mindestens eine Maskierkörper (14) nicht Teil der mindestens einen Trägereinheit (6) ist und die Siegelbereiche die Abstützflächenbereiche nicht umfassen.
